(19) Europäisches Patentamt

European Patent Office

Office européen des brevets

(11) **EP 0 908 893 B1**

(12) **EUROPÄISCHE PATENTSCHRIFT**

(45) Veröffentlichungstag und Bekanntmachung des Hinweises auf die Patenterteilung:
**30.11.2005  Patentblatt 2005/48**

(51) Int Cl.⁷: **G11C 8/00**

(21) Anmeldenummer: **98116942.8**

(22) Anmeldetag: **05.09.1998**

(54) **Speicherarchitektur mit Mehrebenenhierarchie**

Multiplane memory architecture

Architecture de mémoire multiplans

(84) Benannte Vertragsstaaten:
**DE FR GB IT**

(30) Priorität: **16.09.1997  DE 19740695**

(43) Veröffentlichungstag der Anmeldung:
**14.04.1999  Patentblatt 1999/15**

(73) Patentinhaber: **Infineon Technologies AG**
**81669 München (DE)**

(72) Erfinder: **Mattausch, Hans-Jürgen, Prof.**
**Higashi-Hiroshima 739-8527 (JP)**

(74) Vertreter: **Reinhard - Skuhra - Weise & Partner**
**Postfach 44 01 51**
**80750 München (DE)**

(56) Entgegenhaltungen:
EP-A- 0 578 900          US-A- 5 542 067
US-A- 5 659 711

- DATABASE INSPEC [Online] INSTITUTE OF ELECTRICAL ENGINEERS, STEVENAGE, GB SILVANO C ET AL: "Ramgen: a dual port static RAM generator" Database accession no. 4601844 XP002127976 & PROCEEDINGS OF FIFTH ANNUAL IEEE INTERNATIONAL ASIC CONFERENCE AND EXHIBIT (CAT. NO.92TH0475-4), ROCHESTER, NY, USA, 21-25 SEPT. 1992, Seiten 509-512, 1992, New York, NY, USA, IEEE, USA ISBN: 0-7803-0768-2
- SHINAGAWA S ET AL: "A MULTI-SPEED DIGITAL CROSS-CONNECT SWITCHING VLSI USING NEW CIRCUIT TECHNIQUES IN DUAL PORT RAMS" PROCEEDINGS OF THE CUSTOM INTEGRATED CIRCUITS CONFERENCE,US,NEW YORK, IEEE, Bd. CONF. 13, Seite 3401-3404 XP000806435 ISBN: 0-7803-0015-7
- PATENT ABSTRACTS OF JAPAN vol. 1996, no. 12, 26. Dezember 1996 (1996-12-26) & JP 08 212776 A (HITACHI LTD), 20. August 1996 (1996-08-20)

**Beschreibung**

Die Erfindung betrifft eine aus Speicherzellen aufgebaute Speicherarchitektur mit Mehrebenenhierarchie.

Künftige mikroelektronische Schaltungen werden komplizierte Systeme mit Transistorenzahlen im Bereich von $10^{12}$ bis $10^{15}$ realisieren. Diese Systeme, wie zum Beispiel Parallelprozessorsysteme, Systeme der künstlichen Intelligenz oder Multimediasysteme, werden in der Regel mehrere kooperierende Subsysteme zur Verarbeitung von Daten enthalten. Ein entscheidendes Problem für die effiziente praktische Realisierung dieser künftigen Systeme wird somit die Speicherung der zu verarbeitenden Daten sowie derer Datenverarbeitungsprogramme sein. Die leistungsfähigsten Systeme werden sich sicherlich dann realisieren lassen, wenn ein Speicher zur Verfügung steht, auf den die Subsysteme zeitlich parallel und mit hoher Bandbreite zugreifen können. Derartige Speicher, die mehrere Ports als Außenanschlüsse aufweisen, auf die externe Baugruppen zeitlich parallel zugreifen können, werden allgemein als Multi-Port-Speicher bezeichnet.

Eine aus ökonomischen Gründen besonders wichtige Randbedingung ist hierbei natürlich ein möglichst geringer Flächenaufwand auf dem Chip. Weitere Randbedingungen ergeben sich aus der Forderung einer möglichst geringen Zugriffszeit auf die Speicherzellen bzw. die Ports und einer möglichst geringen Verlustleistung des gesamten Speichersystems.

Aus L. A. Glasser & D. W. Dobberpohl, "The Design and Analysis of VLSI-Circuits", Addison-Wesley, ISBN 0-201-12580-3, Seiten 388 - 390, ist ein derartiger Multi-Port-Speicher angegeben. Dieses Dokument zeigt einen Multi-Port-Speicher, der die gewünschte Zahl der externen Ports in jeder einzelnen Speicherzelle implementiert. Jede einzelne Speicherzelle belegt deshalb sehr viel Chipfläche. Außerdem kommt hier ein erheblicher Decodieraufwand für jedes Port hinzu, so daß der komplette Multi-Port-Speicher letztlich äußerst flächenaufwendig wird. Diese einfachste Realisierung eines Multi-Port-Speichers ist somit auch die flächenungünstigste und somit die teuerste Lösung.

Aus K. Guttag, R. J. Gove, J. R. van Aken, "A Single Chip Multiprocessor for Multimedia: The MVP", IEEE Computer Graphics & App., vol. 12, 1992, Seiten 53 - 64, ist ein weiterer Multi-Port-Speicher bekannt. Das oben beschriebene Problem wird hier gelöst durch einen sogenannten Kreuzschienenverteiler, auf dessen Eingangsseite sich die gewünschten externen Ports befinden, und auf dessen Ausgangsseite mehrere konventionelle Speicherblöcke mit 1-Port-Speicherzellen angeschlossen sind. Dieser Ansatz kommt zwar vorteilhafterweise mit 1-Port-Speicherzellen aus, jedoch benötigt der Kreuzschienenverteiler, der häufig auch als Switching-Network bezeichnet wird, in der Praxis ebenfalls sehr viel Chipfläche und erzeugt wegen der langen Verdrahtungsleitungen eine hohe Verlustleistung. Da nicht sehr viele Speicherblöcke angeschlossen werden können, ist die Anzahl der nicht erfolgreichen Zugriffe, das heißt, wenn mehr als ein Port zur selben Zeit auf einen bestimmten Speicherblock zugreift, relativ hoch.

Die Verwendung von hierarchisch aufgebauten Speicherarchitektur sind für andere Aufgabestellungen aus der Literatur bekannt. Die wichtigste dieser Aufgabenstellungen war bislang die Verkürzung der effektiven Zugriffszeit über ein einziges, konventionelles externes Port. Die Verkürzung der effektiven Zugriffszeit ist speziell bei den im Prinzip langsamen dynamischen Speichern (DRAMs) wichtig, um keinen zu großen Unterschied im Bezug auf die Taktraten der heute standardmäßig eingesetzten Mikroprozessoren entstehen zu lassen. Die Zugriffszeit bei einer Speicheranordnung ergibt sich im wesentlichen aus der Laufzeit der Datensignale auf der Wortleitung und aus der Umladung der Speicherkapazitäten. Durch die hierarchische Anordnung wird versucht, die effektive Länge der Leiterbahnen zu verkürzen, um damit die Zugriffszeit entsprechend zu verringern.

Eine Speicheranordnung, die nach der Banking-Technik arbeitet, ist gewissermaßen ein derartig hierarchisch aufgebauter Speicher. In der Banking-Technik wird die Tatsache ausgenutzt, daß der Datentransport über einen Datenbus wesentlich schneller ist, als ein Speicherzugriff. Es ist deshalb im Prinzip möglich, Daten aus mehreren Speicherblöcken parallel auszulesen, in schnellen Registern zwischenzuspeichern und mit hoher Geschwindigkeit über einen Datenbus nach extern auszugeben. Für die Anwendung der Banking-Technik ist es jedoch sehr wichtig, daß sich die sequentiell angeforderten Daten mit hoher Wahrscheinlichkeit in unterschiedlichen Blöcken befinden. Falls dies nicht der Fall ist, müssen Zugriffswünsche zurückgewiesen werden. Der wesentliche Bestandteil beim Banking ist deshalb der detaillierte Algorithmus zur Verteilung der gespeicherten Daten auf die einzelnen Speicherblöcke. In der Praxis ist die Speicherblockzahl beim Banking auf eine relativ kleine Anzahl von Speicherblöcken, üblicherweise 32 Speicherblöcke, beschränkt. Zudem sind hier die Zugriffszeiten auf die einzelnen Speicherblöcke langsam.

Eine Speicherarchitektur, die ebenfalls eine Speicherhierarchie ausnutzt, ist aus der EP 0 393 434 B1 bekannt. Hier ist ein in Mehrebenenhierarchie aufgebauter Speicher angegeben, der ein einziges konventionelles externes Port aufweist. Dabei wird die Tatsache ausgenutzt, daß die Signallaufzeit im kritischen Leitungspfad bei einer Unterteilung des Speichers in mehrere Hierarchieebenen verkürzt werden kann. Allerdings soll hier durch die hierarchische Speicherunterteilung die Belastung von Teilen des kritischen Pfades vermieden werden. Aufgrund der extrem hohen parasitären Kapazitäten und Widerstände in den Wortleitungs- und Bitleitungsabschnitte würde es sonst zu langen Signalwechselzeiten und damit zu großen Zugriffszeiten auf den externen Port kommen.

Bezüglich weiterer Einzelheiten, Merkmale, deren Vorteile und Wirkungsweise von hierarchisch aufgebauten 1-Port-Speicherarchitekturen wird ausdrücklich auf das Europäische Patent EP 0 393 434 B1 verwiesen und Bezug genommen.

Aus der EP 0 578 900 ist ein RAM-Speicher mit mehreren Hierarchieebenen bekannt, wobei die Grundelemente aus Speicherzellenpaaren, die jeweils zwei Leseleitungen aufweisen, aufgebaut ist. Dort ist jedoch nicht vorgesehen, eine Mehrzahl von Ausgangsports in den jeweiligen Hierarchieebenen herauszuführen.

Ausgehend von diesem Stand der Technik liegt daher der Erfindung die Aufgabe zugrunde, eine Speicherarchitektur aus Speicherblöcken mit Mehrebenenhierarchie anzugeben, die eine Mehrzahl von externen Ports über die Daten aus mehreren Speicherblöcken parallel auslesbar sind und auf die externe Baugruppen zeitlich parallel und mit hoher Bandbreite zugreifen können.

Erfindungsgemäß wird diese Aufgabe gelöst durch eine Multiport-Speicherarchitektur mit den Merkmalen des Patentanspruchs 1.

Die erfindungsgemäße Speicherarchitektur mit Mehrebenenhierarchie weist somit eine Vielzahl von externen Anschlussports auf, die gleichzeitig vollkommen parallel ansteuerbar sind.

Bezüglich weiterer Einzelheiten, Merkmale, deren Vorteile und Wirkungsweise von hierarchisch aufgebauten 1-Port-Speicherarchitekturen wird ausdrücklich auf das Europäische Patent EP 0 393 434 B1 verwiesen und vollinhaltlich Bezug genommen ("incorporated by reference").

Ausgehend von diesem Stand der Technik liegt daher der Erfindung die Aufgabe zugrunde, eine Speicherarchitektur mit Mehrebenenhierarchie anzugeben, die eine Mehrzahl von externen Ports aufweist.

Erfindungsgemäß wird diese Aufgabe gelöst durch eine Speicherarchitektur

- mit einer Mehrzahl von Hierarchieebenen,
- mit mindestens einem Speicherblock in jeder der Hierarchieebenen wobei die Speicherblöcke in der untersten Hierarchieebene jeweils aus einzelnen Speicherzellen bestehen,
  wobei jede nächsthöhere Hierarchieebene Speicherblöcke enthält, die jeweils aus Speicherblöcken aus der nächstniedrigeren Hierarchieebene aufgebaut sind,

  - mit Decodereinrichtungen in jeder der Hierarchieebenen, zum Ansteuern, Lesen und Schreiben der jeweiligen Speicherblökke,
  - mit mindestens einer I/O-Schnittstelle, die eine Mehrzahl von I/O-Ports aufweist, wobei die I/O-Ports parallel gleichzeitig und voneinander unabhängig ansteuerbar sind, und
  - mit mindestens einer Adreßauswahlschaltung und mit mindestens einer Portauswahlpufferschaltung in mindestens einer der Hierarchieebenen.

Die erfindungsgemäße Speicherarchitektur mit Mehrebenenhierarchie weist somit eine Vielzahl von externen Anschlußports auf, die gleichzeitig vollkommen parallel ansteuerbar sind. Jede dieser Hierarchieebenen weist eine Vielzahl von verschiedenen Speicherblöcken auf. Die Speicherblöcke in der untersten Hierarchieebene bestehen dabei aus einer Vielzahl von Speicherzellen. Es wäre auch denkbar, daß die unterste Hierarchieebene aus nur einer einzigen Speicherzelle besteht. Üblicherweise ist die Verwendung von zwei Hierarchieebenen für die meisten Anforderungen völlig ausreichend. Allerdings sollte dann der Speicherblock in der untersten Hierarchieebene mindestens aus einer Vielzahl von Speicherzellen bestehen.

Die erfindungsgemäße Mehrport-Speicherarchitektur erlaubt es vorteilhafterweise, 1-Port-Speicherzellen in der untersten Hierarchieebene zu verwenden. Es wäre selbstverständlich auch denkbar, 2-Port- oder Multi-Port-Speicherzellen zu verwenden. Die Verwendung von 1-Port-Speicherzellen erweist sich jedoch aus Gründen der Flächenoptimierung, insbesondere wegen der elektrischen Leiterbahnen (Wortleitungen und Bitleitungen), als besonders vorteilhaft. Auf der Basis von SRAM-Designdaten kann gegenüber der Verwendung von Multi-Port-Speicherzellen in Abhängigkeit von der Portzahl eine ansteigende Flächenersparnis von ca. 30 % bei zwei Ports bis ca. 70 % bei 16 Ports erzielt werden. Die Verwendung von derartigen statischen 1-Port-Speicherzellen (SRAM-Speicherzellen) erweist sich somit auch als besonders kostengünstig.

Die Anordnung der Speicherblöcke in den verschiedenen Hierarchieebenen kann dabei verschiedenartig ausgestaltet sein. Besonders vorteilhaft ist es, wenn die Speicherblöcke einer Hierarchieebene matrixförmig angeordnet sind. Besonders vorteilhaft ist es dabei, wenn die Anzahl der Spalten und Zeilen der Speicherblockmatrix ein Vielfaches von zwei ist.

Es ist jedoch auch denkbar, daß die Speicherblöcke in den Hierarchieebenen in einer Switching-Network-Anordnung, in Banking-Technik oder ähnlichem angeordnet werden. Die Anordnung der verschiedenen Speicherblökke innerhalb der verschiedenen Hierarchieebenen ist dabei der Freiheit des Systemdesigns überlassen. Es wäre auch denkbar, wenn in den verschiedenen Hierarchieebenen jeweils eine unterschiedliche Anordnung der Speicherblöcke verwendet wird.

Neben der Anwendung bei der Systemintegration kann die Erfindung selbstverständlich auch für flächengünstige Multi-Port-Speicherchips genutzt werden. Sie ist auf keine spezielle Speicherart beschränkt, sondern ist für alle Arten von nichtflüchtigen, statischen und dynamischen Speichern und der zugrunde gelegten Speichertechnologie anwendbar. Besonders vorteilhaft ist die Erfindung dabei bei statischen Speichern (SRAMs) und dynamischen Speichern (DRAMs). Jedoch zeigt sich die Erfindung insbesondere auch bei Logikspeichern, zum Beispiel bei allen Arten von programmierbaren Festwertspeichern (PROMs, EPROMs, EEPROMs), als vorteilhaft. Darüber hinaus ist die erfindungsgemäße Speicherarchitektur auch sinnvoll bei konventionellen ROM-Speichern. ROM-Speicher werden bevorzugt in Prozessorbauelementen und eine Anwendung der hierarchischen Architektur ist hier aus Platzgründen besonders attraktiv.

Es wäre auch denkbar, wenn in den verschiedenen Ebenen unterschiedliche Technologien zur Anwendung kommen. Zum Beispiel könnte für die sogenannten "embedded" Speicher die unterste Ebene in Speichertechnologie und die oberen Hierachiebenen in Logiktechnologie gefertigt sein. Die verwendete Speicherarchitektur ist somit weitgehend unabhängig von der verwendeten Technologie. Die Erfindung ist insbesondere bei dynamischen Speicheranordnungen (DRAM) vorteilhaft, da hier die Kapazitäten der Speicherzellen aufgrund der geringeren effektiven Leitungslängen verhältnismäßig gering dimensioniert werden können.

Trotz der Anordnung des Speichers in mehrere Hierachieebenen verschlechtert sich die Zugriffszeit pro Port nicht. Es tritt hier der Effekt einer gegenläufigen Entwicklung auf. Aufgrund von zusätzlichen Gattern, wie zum Beispiel einem zusätzlichen Multiplexer, verschlechtert sich zwar die Zugriffszeit durch die zusätzliche Laufzeit. Allerdings sind die Abmessungen der einzelnen Speicherblöcke und somit auch derer Leiterbahnen kleiner ausgebildet, was wiederum eine Verringerung der Zugriffszeit bedeutet. Aufgrund der verringerten parasitären Kapazitäten und Widerstände im kritischen Leitungspfad wird die Zugriffszeit überdies noch verbessert.

Die Tatsache, daß pro Port und pro Zugriff jeweils nur ein einziger Speicherblock auf den oberen Hierachieebenen aktiviert wird und die übrigen, nicht verwendeten Speicherblöcke gewissermaßen abgeschaltet sind, führt zu einer geringeren Verlustleistung der gesamten Speicherarchitektur. Die übrigen, nicht verwendeten Speicherblöcke sind somit quasi abgeschaltet.

Multi-Port-Speicherarchitekturen nach dem Stand der Technik sind zudem in ihrem Design beschränkt durch die sogenanntenten Rasterschaltungen, die im wesentlichen aus den Zeilen- und den Spaltendekoderschaltungen bestehen. Insbesondere bei sehr vielen Anschlußports lassen sich die Steuerleitungen der Dekoderschaltungen mit den darin enthaltenen Treibern nicht mehr zu den entsprechenden Speicherzellen führen. Die Zahl der Anschlußports derartiger Multi-Port-Speicherarchitekturen ist somit vom Design begrenzt. Durch die Erfindung ist es vorteilhafterweise möglich, das Design der Multi-Port-Speicherarchitektur an die gegebenen Platzanforderungen anzupassen. Die verschiedenen Rasterschaltungen lassen sich auf mehrere Hierachieebenen verteilen. Zudem lassen sich die Anschlußports der Multi-Port-Speicherarchitektur auf die verschiedenen Hierachiebenen verteilen. Somit erlaubt die gegebene Mehrebenehierarchie eine beliebige Designfreiheit.

Die weiteren Unteransprüche sind auf bevorzugte Ausgestaltungen und Weiterbildungen des Speichers gerichtet.

Die Erfindung wird nachfolgend anhand der in den Figuren der Zeichnung angegebenen Ausführungsbeispiele näher erläutert. Es zeigt dabei:

Figur 1    eine statische 1-Port-Speicherzelle (a) im Vergleich mit einer statischen Multi-Port-Speicherzelle (b);

Figur 2    ein Beispiel einer erfindungsgemäßen Multi-Port-Speicherarchitektur mit Mehrebenenhierarchie.

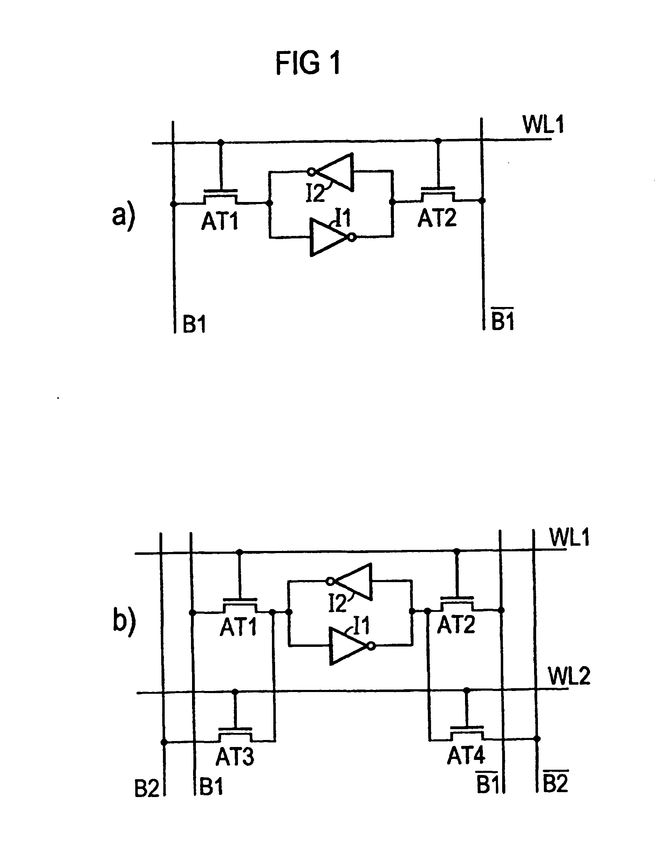

Figur 1 zeigt eine statische 1-Port-Speicherzelle (a) im Vergleich mit einer statischen Multi-Port-Speicherzelle (b), die im vorliegenden Beispiel zwei Anschlußports aufweist.

Die 1-Port-Speicherzelle in Figur 1 (a) weist zwei Auswahltransistoren $AT1$, $AT2$ sowie zwei Inverter $I1$, $I2$ auf. Der erste Auswahltransistor $AT1$ ist hierbei zwischen einer Datenleitung $B1$ zum Einlesen/Auslesen von Informationen und einem Eingang des ersten Inverters $I1$ geschaltet, wobei der zweite Inverter $I2$ auf den Inverter $I1$ parallel rückgekoppelt ist. Der zweite Auswahltransistor $AT2$ der Speicherzelle ist zwischen einem Ausgang des ersten Inverters $I1$ und einer Datenleitung $\overline{B1}$ geschaltet, wobei die zweite Datenleitung $\overline{B1}$, die zu der ersten Datenleitung $B1$ invertierten Signale aufweist. Die Steueranschlüsse der Auswahltransistoren $AT1$, $AT2$ sind zusätzlich mit einer Wortleitung $WL1$ verbunden. Über die Wortleitungen $WL1$ lassen sich die Auswahltransistoren $AT1$, $AT2$ in den leitenden Zustand bzw. in den gesperrten Zustand steuern.

In Figur 1(b) ist eine Multi-Port-Speicherzelle angegeben, die im vorliegenden Beispiel zwei Ports aufweist. Diese sogenannte 2-Port-Speicherzelle ist ähnlich wie die 1-Port-Speicherzeile aus Figur 1(a) aufgebaut. Die 2-Port-Speicherzelle weist zusätzlich noch zwei weitere Auswahltransistoren $AT3$, $AT4$ auf, die entsprechend wie die Auswahltransistoren $AT1$, $AT2$ mit den beiden Invertern $I1$, $I2$ der Speicherzelle gekoppelt sind. Desweiteren weist die 2-Port-Speicherzelle in Figur 1(b) eine zweite Wortleitung $WL2$ sowie zwei weitere Datenleitungen $B2$, $\overline{B2}$ auf. Die Wortleitung $WL2$ sowie die Datenleitungen $B2$, $\overline{B2}$ sind entsprechend wie in Figur 1(a) mit den entsprechenden Auswahltransistoren $AT3$, $AT4$ verbunden.

Dabei bilden die Leitungen WL1, B1, B$\overline{1}$ den ersten Port der Speicherzelle und die Leitungen WL2, B2, B$\overline{2}$ den zweiten Port der Speicherzelle. Multi-Port-Speicherzellen mit einer entsprechenden Anzahl von Ausgangsports sind dann ausgehend von der Speicherzelle in Figur 1 mit einer entsprechenden Anzahl von Auswahltransistoren bzw. Leitungen versehen. Mit zunehmender Anzahl von Ports einer Speicherzelle nimmt somit auch der Verdrahtungsaufwand wie eingangs erwähnt zu. Ausgehend vom Flächenaufwand ist somit die 1-Port-Speicherzelle die flächengünstigste Form.

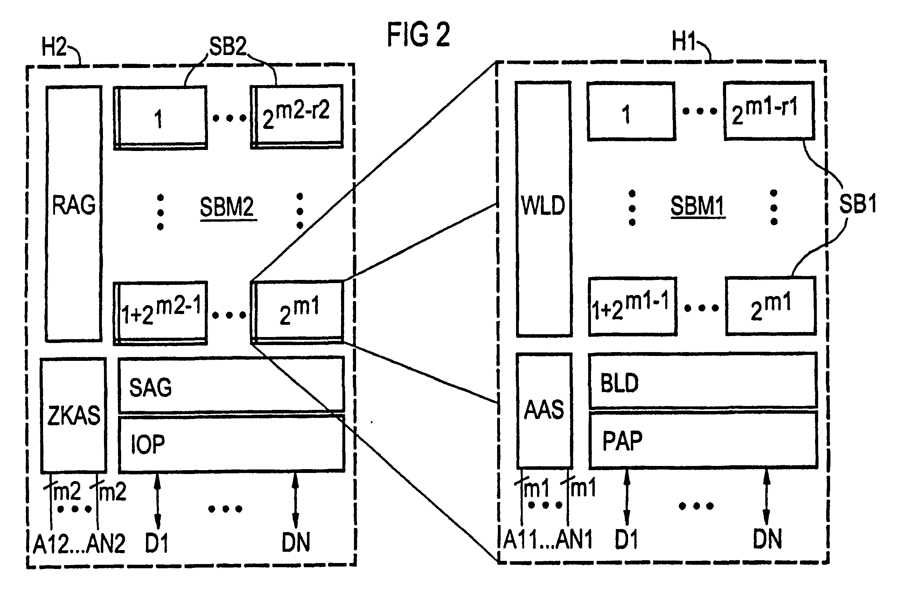

Die erfindungsgemäße Speicherarchitektur benutzt eine speicherinterne 2-Ebenen-Hierarchie, um den Übergang eines einzigen, in jeder Speicherzelle implementierten Ports auf die externen Ports des Multi-Port-Speichers zu bewerkstelligen. Das Prinzip dieser erfindungsgemäßen Multi-Port-Speicherarchitektur mit Mehrebenenhierarchie ist in Figur 2 gezeigt. Im vorliegenden Beispiel sind zwei Hierarchieebenen und eine Anzahl N Ausgangsports dargestellt.

Die erfindungsgemäße Speicherarchitektur mit Mehrebenenhierarchie weist im vorliegenden Beispiel zwei Hierarchieebenen H1, H2 auf. Es wäre auch denkbar, mehr als zwei Hierarchieebenen zur Realisierung der erfindungsgemäßen Speicherarchitektur zu verwenden. Dabei wird die erste Hierarchieebene mit H1 bezeichnet, während die zweite Hierarchieebene mit H2 bezeichnet wird. Desweiteren werden nachfolgend die Elemente der ersten Hierarchieebene H1 mit dem Index 1 versehen, während die Elemente der zweiten Hierarchieebene H2 mit dem Index 2 versehen werden.

Der Übersichtlichkeit halber sind in allen Hierarchieebenen H1, H2 die Verdrahtungsleitungen, dabei insbesondere die Wortleitungen und Bitleitungen, nicht eingezeichnet worden.

Im vorliegenden Ausführungsbeispiel sind beide Hierarchieebenen H1, H2 äquivalent aufgebaut und enthalten jeweils eine Speicherblockmatrix sowie Auswahlmittel zum gezielten Auslesen einzelner Speicherblöcke, die im vorliegenden Beispiel als Zeilendecoder und Spaltendecoder ausgebildet sind, sowie eine Schnittstelle zur nächsthöheren Hierarchieebene.

Es ist selbstverständlich auch denkbar, daß die Speicherblöcke in den unterschiedlichen Hierarchieebenen auf unterschiedliche Art und Weise angeordnet sind. So wäre es beispielsweise denkbar, daß die Speicherblöcke in einer der Hierarchieebenen in Switching-Network-Anordnung angeordnet sind, während die Speicherblöcke in einer anderen Hierarchieebene zum Beispiel in einer bekannten Speicherblockmatrix angeordnet sind. Es ist somit nicht zwingend notwendig, daß die unterschiedlichen Hierarchieebenen H1, H2 gleichartig zueinander angeordnet sind. Die Anordnung der Speicherblöcke in den jeweiligen Hierarchieebenen kann somit an die Anwendung bzw. an die Anforderungen des Anwenders angepaßt werden und ist somit ein weiterer Freiheitsgrad im Design der Speicherarchitektur.

Die erste Hierarchieebene H1 enthält eine erste Speicherblockmatrix SBM1. Desweiteren enthält die erste Hierarchieebene H1 einen Wortleitungsdecoder WLD, einen Bitleitungsdecoder BLD, eine Portauswahlpufferschaltung PAP, sowie eine Adreßauswahlschaltung AAS.

Die Speicherblockmatrix SBM1 der ersten Hierarchieebene H1 umfaßt im vorliegenden Beispiel eine Anzahl M1 = 2m1 verschiedene Speicherblöcke SB1, die matrixförmig angeordnet sind. Im vorliegenden Beispiel umfaßt dabei die Speicherblockmatrix SBM1 eine Anzahl $2^{m1-r1}$ Spalten und eine Anzahl $2^{r1}$ Zeilen. Die Anzahl der Zeilen und Spalten der Speicherblockmatrix SBM1 ist somit ein Vielfaches von 2. Dies ist zwar nicht zwingend notwendig, jedoch bei einer derartigen Speicherblockmatrix vorteilhaft.

Die Speicherblöcke SB1 der ersten Hierarchieebene H1 bestehen aus verschiedenen Speicherzellen. Im vorliegenden Beispiel sind die Speicherzellen in der ersten Hierarchieebene 1-Port-Speicherzellen mit einem einzigen Schreib/Lese-Port. Es wäre selbstverständlich auch denkbar, daß die genannten Speicherzellen sogenannte Mehr-Port-Speicherzellen mit einer entsprechenden Anzahl von Schreib/Lese-Ports sind. Aus den in der Beschreibungseinleitung sowie in Zusammenhang mit Figur 1 gemachten Ausführungen ist jedoch die Verwendung von 1-Port-Speicherzellen in der untersten Hierarchieebene H1 besonders vorteilhaft. Allerdings kann die Verwendung von derartigen Multi-Port-Speicherzellen in der untersten Hierarchieebene H1 für bestimmte Anforderungen, beispielsweise der Zugriffszeit- und Flächenoptimierung eines Designs, günstig sein. Insbesondere kann es vorteilhaft sein, um bei einer geringen Anzahl von Speicherblöcken auf einer der höheren Hierarchieebenen die Konfliktwahrscheinlichkeit eines Zugriffs zu reduzieren.

Die Speicherzellen in der ersten Hierarchieebene H1 können dabei als beliebige nichtflüchtige Speicherzellen (z. B. EEPROM-Speicherzellen), statische Speicherzellen (z. B. SRAM-Speicherzellen) oder dynamische Speicherzellen (z. B. DRAM-Speicherzellen) ausgestaltet sein. Die peripheren Schaltungen der Speicherblöcke müssen natürlich passend zu dem gewählten Typ der Speicherzellen ausgebildet sein.

Zur Auswahl einer einzigen bzw. mehrerer Speicherzellen in der untersten Hierarchieebene H1 ist ein Bitleitungsdecoder BLD sowie ein Wortleitungsdecoder WLD vorgesehen. Im vorliegenden Beispiel weist der Bitleitungsdecoder BLD eine Anzahl m1-r1 Adreßbits auf und der Wortleitungsdecoder WLD weist eine Anzahl r1 Adreßbits auf. Desweiteren weist die erste Hierarchieebene H1 eine Adreßauswahlschaltung AAS auf, die von einer Anzahl N unterschiedlicher Adressen A11 bis AN1 angesteuert wird. Jede dieser Adressen weist eine Breite von m1-Adreßbits auf.

Desweiteren weist die erste Hierarchieebene H1 eine Portauswahlpufferschaltung PAP mit einer Anzahl N unterschiedlicher Ausgangsports D1 bis DN auf.

Die Funktionsweise der Speicheranordnung in der ersten Hierarchieebene H1 erfolgt bei einem Auslesevorgang wie folgt: Von der Adreßauswahlschaltung AAS wird über die Adreßports A11 bis AN1 ein Adreßwort eingekoppelt. Ausgehend von diesem eingekoppelten Adreßwort steuert der Wortleitungsdecoder WLD und Bitleitungsdecoder BLD die jeweiligen Speicherzellen in der Speicherblockmatrix SBM1 derart an, daß ein Datenwort ausgelesen werden kann. Dieses Datenwort wird der Portauswahlpufferschaltung PAP zugeführt. Die Portauswahlpufferschaltung PAP weist dieses Datenwort einem der Ausgangsports D1 bis DN zu. Für einen Schreibvorgang verläuft dieser Zyklus äquivalent in entgegengesetzter Richtung.

Desweiteren weist die Speicherarchitektur entsprechend Figur 2 eine zweite Hierarchieebene H2 auf. Die zweite Hierarchieebene H2 weist eine zweite Speicherblockmatrix SBM2, einen Reihenauswahlgenerator RAG, einen Spaltenauswahlgenerator SAG sowie eine Input/Output-Pufferschaltung IOP auf. In der zweiten Hierarchieebene H2 sind die Speicherblöcke SB2 im vorliegenden Beispiel ebenfalls als Speicherblockmatrix SBM2 ausgebildet.

Der Aufbau der zweiten Speicherblockmatrix SBM2 in der zweiten Hierarchieebene H2 ist äquivalent zu dem in der ersten Hierarchieebene H1. Selbstverständlich ist hier auch eine andere Anordnung der Speicherblöcke, beispielsweise ein Switching-Network oder in sogenannter Banking-Technik angeordnete Speicherblöcke, denkbar. Im vorliegenden Beispiel weist die Speicherblockmatrix SBM2 eine Anzahl $2^{m2-r2}$ unterschiedliche Spalten und eine Anzahl $2^{r2}$ unterschiedlicher Zeilen auf. Äquivalent wie bei der ersten Speicherblockmatrix SBM1 ist bei der zweiten Speicherblockmatrix SBM2 die Anzahl der Zeilen bzw. Spalten ein Vielfaches von 2, wobei auch eine gängige andere Anzahl von Spalten und Zeilen denkbar wäre.

Desweiteren weist die zweite Hierarchieebene H2 einen Reihenauswahlgenerator RAG zur Auswahl der verschiedenen Reihen sowie einen Spaltenauswahlgenerator SAG zur Auswahl der verschiedenen Spalten der zweiten Speicherblockmatrix SBM2 auf. Der Reihenauswahlgenerator RAG weist somit N verschiedene Ports mit jeweils r2 verschiedenen Adreßbits auf. Der Spaltenauswahlgenerator SAG weist ebenfalls N verschiedene Ports mit jeweils m2-r2 Adreßbits auf.

Die Auswahl der Speicherblöcke SB2 in der zweiten Hierarchieebene H2 erfolgt über die sogenannte Input/Output-Pufferschaltung IOP (I/O-Pufferschaltung). Die I/O-Pufferschaltung IOP weist ebenfalls eine Anzahl N verschiedene Ausgangsports D1 bis DN auf. Die Ausgangsports stellen somit die Ausgangsports der Multi-Port-Speicherarchitektur dar.

Es wäre selbstverständlich auch möglich, daß eine oder mehrere Hierarchieebenen H1, H2 jeweils nur aus einem einzigen Speicherblock besteht. Im Falle der untersten Hierarchieebene H1 würde sich dann die Speicherblockmatrix SBM1 zu einem einzelnen Speicherblock SB1 und damit zu einer einzelnen Speicherzelle reduzieren.

Erfindungsgemäß sind die Speicherblöcke SB2 in der zweite Hierarchieebene H2 jeweils aus Speicherblöcken SB1 und den jeweiligen Peripherieeinheiten der ersten Hierarchieebene H1 aufgebaut.

Ist die Speicherarchitektur aus einer Vielzahl von Hierarchieebenen aufgebaut, dann ergibt sich der Aufbau des Speichers wie folgt: In der untersten Hierarchieebene H1 setzen sich die Speicherblöcke SB1 aus einer Anzahl von mindestens einer Speicherzelle zusammen. Die zugehörigen Peripherieeinheiten, wie Wortleitungsdecoder WLD, Bitleitungsdecoder BLD, Portauswahlpufferschaltung PAP, Adreßauswahlschaltung AAS sind an die jeweilige Anordnung der Speicherblöcke in der jeweiligen Hierarchieebene angepaßt. Jede nächsthöhere Hierarchieebene setzt sich dann aus Speicherblöcken der nächstniedrigeren Hierarchieebene zusammen. Die oberste Hierarchieebene weist dann zusätzlich eine I/O-Pufferschaltung IOP mit den entsprechenden Ausgangsports der Speicherarchitektur auf. Die Anzahl N der verschiedenen Ausgangsports D1 bis DN sind dann die Ports der Multi-Port-Speicherarchitektur.

Die zweite Hierarchieebene H2 setzt sich somit aus einer Anzahl $M2 = 2^{m2}$ verschiedenen Speicherblöcken SB2 zusammen, wobei jeder einzelne Speicherblock SB2 eine Anzahl $M1 = 2^{m1}$ verschiedene Speicherzellen enthält. Die Gesamtzahl der Speicherzellen der Speicherarchitektur errechnet sich somit aus $M = M1 * M2 = 2^m$ , wobei $m = m1 + m2$ ist.

Desweiteren ist in Hierarchieebene H2 erfindungsgemäß eine Schaltungsanordnung zur Behandlung von Zugriffskonflikten vorgesehen. Diese sogenannte Zugriffskonfliktausworteschaltung ist insbesondere bei einer Multi-Port-Speicherarchitektur zwingend notwendig, wenn beispielsweise zwei oder mehr Ports auf denselben Speicherblock zugreifen.

In diesem Fall muß eine Priorisierung der Zugriffsauswahl stattfinden. Die Zugriffskonfliktausworteschaltung ZKAS ist bei allen konventionellen N-Port-Speicherarchitekturen und somit auch bei einer einzelnen N-Port-Speicherzelle notwendig, da der Zugriff von zwei oder mehr Ports auf dieselbe Speicherzelle zumindest bei einem Schreibzugriff nicht erlaubt ist und einen Konflikt darstellt.

Nachfolgend werden die Funktionen der wichtigsten Teilschaltüngen näher erläutert. Dabei wird zunächst die Funktion der N-Port-Speicherarchitektur während eines Zugriffs über die N-Ports kurz beschrieben. Für die meisten in der Architektur vorkommenden Schaltungen gibt es allgemein bekannte und eingesetzte Lösungen nach dem Stand der Technik.

Der Reihenauswahlgenerator RAG und Spaltenauswahlgenerator SAG generieren für jedes der N Ports aus den jeweiligen m2-Adreßbits der zweiten Hierarchieebene H2 Zeilen- und Spaltenauswahlsignale. Parallel dazu prüft die Zugriffskonfliktauswerteschaltung ZKAS die Adreßbits der zweiten Hierarchieebene H2 auf eine oder mehrere Konfliktsituationen. Die Aktivierung des entsprechenden Speicherblocks SB2 wird erst dann freigegeben, wenn die Zugriffskonfliktprüfung beendet ist und wenn für Zugriffskonfliktfälle nach einem vorgegebenen Priorisierungsalgorithmus jeweils ein Port als zugriffsberechtigt ausgewählt wird. Somit sind auf der zweiten Hierarchieebene H2 jeweils nur ein Speicherblock SB2 pro Port aktiviert.

Bei N-Port-Speicherarchitekturen, beispielsweise bei einer N-Port-Speicherzelle, wurde ein Zugriffskonflikt bislang sequentiell gelöst. Diese sequentielle Zugriffskonfliktlösung erweist sich jedoch bei einer N-Port-Speicherarchitektur als nachteilig, da insbesondere bei mehreren Zugriffskonflikten die Leistungsfähigkeit der gesamten Speicherarchitektur dramatisch herabgesetzt wird.

Aus diesem Grund ist es vorteilhaft, wenn Zugriffskonflikte zeitlich vollständig parallel abgearbeitet werden. Eine derartige parallele Abarbeitung von Zugriffskonflikten kann beispielsweise über einen Priorisierungsalgorithmus erfolgen, der jeweils einen Port als zugriffsberechtigt auswählt. Für den Priorisierungsalgorithmus kann beispielsweise eine einfache Staffelung der Ports nach ihrer Bedeutung erfolgen. Im Konfliktfall erhält dann immer das bedeutendste Port das Zugriffsrecht. Mit einem Statussignal wird für jeden Port nach extern signalisiert, ob der aktuelle Zugriff erfolgreich war oder zurückgewiesen wurde.

In der ersten Hierarchieebene H1 werden nur die m1-Adreßbits eines einzigen Ports dem Wortleitungsdecoder WLD und Bitleitungsdecoder BLD zugeführt. Die Aktivierungssignale der Speicherblöcke SB1 enthalten somit nur die Informationen über das zu aktivierende Port. Diese Information wird von der Adreßauswahlschaltung AAS benutzt, um die Adreßbits des zugehörigen Ports auf den entsprechenden Decoder zu schalten. Die Portauswahlpufferschaltung PAP verbindet dann gleichzeitig den Ausgang des Bitleitungsdecoders BLD mit den zu dem Port gehörigen Datenleitungen. Zusätzlich umfaßt der Bitleitungsdecoder BLD eine integrierte Bewertungsschaltung sowei Treibermittel zur Verstärkung der Lesesignale.

Die drei Schaltungen, Portauswahlpufferschaltung PAP, Adreßauswahlschaltung AAS und Zugriffskonfliktauswerteschaltung ZKAS, können nach bekannten Methoden in konventioneller Schaltungstechnik realisiert sein. Bei den ersten beiden Schaltungen, das heißt bei der Portauswahlpufferschaltung PAP und der Adreßauswahlschaltung AAS, handelt es sich um einfache Multiplexer- bzw. Demultiplexerschaltungen.

Die Zugriffskonfliktauswerteschaltung ZKAS hängt selbstverständlich von dem zugrundeliegenden Priorisierungsalgorithmus ab. Insbesondere bei einer vollständig parallelen Zugriffskonfliktlösung kann die Schaltung hier auf der Basis von einem Vergleich der Adreßbits über ein EXOR-Gatter erfolgen. Der zugrundegelegte Priorisierungsalgorithmus bestimmt dann, wie die Ausgänge des EXOR-Gatters zur Generierung der entsprechenden Portfreigabesignale verknüpft werden.

In Figur 2 ist der Einfachheit halber pro Port eine Wortbreite von einem Bit angenommen worden. Selbstverständlich kann die Wortbreite innerhalb der vorgeschlagenen Speicherarchitektur beliebige Werte annehmen. Die Weiterbildung erfolgt dann nach den Methoden des Standes der Technik.

In einer Weiterbildung können selbstverständlich alle bekannten Techniken nach dem Stand der Technik zur Verkürzung der Zugriffszeit verwendet werden, um die erfindungsgemäße Multi-Port-Speicherarchitektur mit Mehrebenenhierarchie weiterzubilden. In Figur 2 ist jedoch die einfachste, hierarchische Anordnung für Speicherblöcke in verschiedenen Hierarchieebenen angegeben. In jeder dieser Hierarchieebenen kann aber zusätzlich auch intern eine der bekannten Techniken zur Verkürzung der Zugriffszeit, zum Beispiel Caching, Banking, etc. eingesetzt werden.

Bezugszeichenliste

| | |
|---|---|
| A11, ..., AN1, A12, ..., AN2 | = Adreßleitungen |
| AAS | = Adreßauswahlschaltung |
| AT1, AT2, AT3, AT4 | = Auswahltransistoren |
| B1, B2 | = Datenleitungen |
| $\overline{B1}$, $\overline{B2}$ | = Datenleitungen mit inversen Signalen |
| BLD | = Bitleitungsdecoder |
| D1, ..., DN | = Ausgangsports |
| H1 | = erste (unterste) Hierarchieebene |
| H2 | = zweite (oberste) Hierarchieebene |
| I1, I2 | = Inverter |
| IOP | = I/O-Pufferschaltung |
| M | = Gesamtanzahl der Speicherblöcke bzw. Speicherzellen der Speicherarchitektur |
| m1, m2 | = Anzahl der Adreßbits |
| M1, M2 | = Gesamtzahl der Speicherblöcke einer Hierarchieebene |

| | |
|---|---|
| N | = Zahl der Ports |
| PAP | = Portauswahlpufferschaltung |
| R1, R2 | = Adreßbits |
| RAG | = Reihenauswahlgenerator |
| SAG | = Spaltenauswahlgenerator |
| SB1, SB2 | = Speicherblöcke |
| W1, W2 | = Wortleitungen |
| WLD | = Wortleitungsdecoder |
| ZKAS | = Zugriffskonfliktauswerteschaltung |

**Patentansprüche**

1.  Multiport-Speicherarchitektur

    (a) mit einer Mehrzahl von Hierarchieebenen (H1, H2),

    (b) mit mindestens einem Speicherblock (SB1, SB2) in jeder der Hierarchieebenen (H1, H2), wobei die Speicherblöcke (SB1) in der untersten Hierarchieebene (H1) jeweils aus einzelnen 1-Port-Speicherzellen bestehen, welche jeweils einzelne Ports aus jeweils einem Adressleitungsanschluß (WL1) und Datenleitungen (B1,/ B1) aufweisen, wobei jede nächsthöhere Hierarchieebene Speicherblöcke (SB2) enthält, die jeweils aus Speicherblöcken (SB2) aus der nächstniedrigeren Hierarchieebene (H1) aufgebaut sind,

    (c) mit Decodereinrichtungen (WLD, BLD, RAG, SAG) in jeder der Hierarchieebenen (H1, H2), zum Ansteuern, Lesen und Schreiben der jeweiligen Speicherblöcke (SB1, SB2),

    (d) mit einer Adreßauswahlschaltung (AAS) in mindestens der untersten Hierarchieebene (H1) zum gleichzeitigen Einkoppeln von N unterschiedlichen Adressen mit jeweils m1 Adressbits (A11, ..., AN1) zum Adressieren jeweiliger Speicherblöcke, die die jeweilige Decodiereinrichtung (WLD, BLD,) derart, steuern, dass für jede der N Adressen jeweils eines von N Datenwörten aus einem jeweiligen Speicherblock (SB1) ausgelesen wird,

    (e) mit einer Portauswahlpufferschaltung (PAP) in mindestens der untersten Hierarchieebene (H1) zum Zuweisen des jeweiligen ausgelesenen Datenworts an einen der Ausgangsports (D1 ..., DN) der jeweiligen Hierarchieebene (H1), und

    (f) mit einer Input/Output-Pufferschaltung (IOP) in der obersten Hierarchieebene (H2) zum Auswählen von Speicherblöcken (SB2) der obersten Hierarchieebene (H2),

    (g) wobei die Portauswahlpufferschaltung (PAP) und die Input/Output-Pufferschaltung (IOP) jeweils N unterschiedliche Ausgangsports (D1, ..., DN) aufweisen, wobei die N Ausgangsports (D1, ..., DN) der Input/Output-Pufferschaltung (IOP) zur parallelen Ausgabe der N Datenworte die Ausgangsports (D1, ..., DN) der Speicherarchitektur bilden.

2.  Multiport-Speicherarchitektur nach Anspruch 1,
    **dadurch gekennzeichnet,**
    **daß** die Speicherblöcke (SB1) in der untersten Hierarchieebene (H1) aus Speicherzellen bestehen, die zwei Datenleitungen (B1) zum Einlesen und Auslesen von Informationen und eine Wortleitung (WL1) zum Ansteuern der Speicherzelle aufweisen.

3.  Multiport-Speicherarchitektur nach einem der vorhergehenden Ansprüche,
    **dadurch gekennzeichnet,**
    **daß** eine Zugriffskonfliktauswerteschaltung (ZKAS) in der obersten Hierarchieebene (H2) vorgesehen ist, die im Falle eines Zugriffskonflikts der Ausgangsports (D1 - DN) der Speicherarchitektur auf denselben Speicherblock (SB2) einen am Zugriff beteiligten Ausgangsport (D1 - DN) freigibt und die übrigen am Zugriff beteiligten Ausgangsports (D1 - DN) sperrt.

4.  Multiport-Speicherarchitektur nach Anspruch 3,
    **dadurch gekennzeichnet,**
    **daß** die Zugriffskonfliktauswerteschaltung (ZKAS) eine Priorisierung der Ausgangsports (D1 - DN) entsprechend ihrer Bedeutung nach einem Priorisierungsalgorithmus vornimmt.

5.  Multiport-Speicherarchitektur nach einem der vorhergehenden Ansprüche,
    **dadurch gekennzeichnet,**

**daß** die Speicherblöcke (SB1, SB2) in mindestens einer der Hierarchieebenen (H1, H2) matrixförmig in einer Speicherblockmatrix (SBM1, SBM2) mit einer ersten Anzahl von Matrixzeilen und einer zweiten Anzahl von Matrixspalten angeordnet sind.

6.  Multiport-Speicherarchitektur nach Anspruch 5,
    **dadurch gekennzeichnet,**
    **daß** die erste Anzahl und/oder die zweite Anzahl ein Vielfaches von 2 ist.

7.  Multiport-Speicherarchitektur nach einem der Ansprüche 5 oder 6,
    **dadurch gekennzeichnet, daß** die Speicherblockmatrix (SBM1, SBM2) mindestens einen Reihendecoder (RAG, WLD) aufweist, der über entsprechende Adreßbits eine Reihenauswahl in der entsprechenden Speicherblockmatrix (SBM1, SBM2) vornimmt.

8.  Multiport-Speicherarchitektur nach einem der Ansprüche 5 bis 7,
    **dadurch gekennzeichnet,**
    **daß** die Speicherblockmatrix (SBM1, SBM2) mindestens einen Spaltendecoder (SAG, BLD) aufweist, der über entsprechende Adreßbits eine Spaltenauswahl in der entsprechenden Speicherblockmatrix (SBM1, SBM2) vornimmt.

9.  Multiport-Speicherarchitektur nach einem der vorhergehenden Ansprüche,
    **dadurch gekennzeichnet,**
    **daß** die Speicherblöcke (SB1, SB2) in mindestens einer der Hierarchieebenen (H1, H2) in einer Switching-Network-Anordnung vorgesehen sind.

10. Multiport-Speicherarchitektur nach einem der Ansprüche 1 bis 8,
    **dadurch gekennzeichnet,**
    **daß** die Speicherblöcke (SB1, SB2) in mindestens einer der Hierarchieebenen (H1, H2) in sogenannter Banking-Technik angeordnet sind.

11. Multiport-Speicherarchitektur nach einem der vorherigen Ansprüche in einem Logikbauelement.

12. Multiport-Speicherarchitektur nach Anspruch 11 mit EEPROM-Speicherzellen.

13. Multiport-Speicherarchitektur nach einem der Ansprüche 1 bis 10 in dynamischen oder statischen Speicherbauelementen.

14. Multiport-Speicherarchitektur nach Anspruch 13
    mit dynamischen DRAM-Speicherzellen.

15. Multiport-Speicherarchitektur nach Anspruch 13
    mit statischen SRAM-Speicherzellen.

16. Multiport-Speicherarchitektur nach einem der vorhergehenden Ansprüche 1 bis 10 in einem ROM-Speicher.

**Claims**

1.  Multiport memory architecture

    (a) having a plurality of hierarchical levels (H1, H2),
    (b) having at least one memory block (SB1, SB2) in each of the hierarchical levels (H1, H2), the memory blocks (SB1) in the bottommost hierarchical level (H1) in each case comprising individual 1-port memory cells which in each case have individual ports comprising in each case an address line connection (WL1) and data lines (B1,/B1), each next-higher hierarchical level containing memory blocks (SB2) which are in each case constructed from memory blocks (SB2) from the next-lower hierarchical level (H1),
    (c) having decoder devices (WLD, BLD, RAG, SAG) in each of the hierarchical levels (H1, H2), for driving, reading from and writing to the respective memory blocks (SB1, SB2),
    (d) having an address selection circuit (AAS) in at least the bottommost hierarchical level (H1) for simultaneously coupling in N different addresses with in each case m1 address bits (A11, ..., AN1) for addressing respective memory blocks, which control the respective decoding device (WLD, BLD) in such a way that, for each of the N addresses, one of N data words is in each case read out from a respective memory block (SB1),

(e) having a port selection buffer circuit (PAP) in at least the bottommost hierarchical level (H1) for allocating the respective data word read out to one of the output ports (D1, ..., DN) of the respective hierarchical level (H1), and

(f) having an input/output buffer circuit (IOP) in the topmost hierarchical level (H2) for selecting memory blocks (SB2) of the topmost hierarchical level (H2),

(g) the port selection buffer circuit (PAP) and the input/output buffer circuit (IOP) in each case having N different output ports (D1, ..., DN), the N output ports (D1, ..., DN) of the input/output buffer circuit (IOP), for the parallel outputting of the N data words, forming the output ports (D1, ..., DN) of the memory architecture.

2. Multiport memory architecture according to Claim 1,
   **characterized**
   **in that** the memory blocks (SB1) in the bottommost hierarchical level (H1) comprise memory cells which have two data lines (B1) for reading in and reading out information items and a word line (WL1) for driving the memory cell.

3. Multiport memory architecture according to one of the preceding claims,
   **characterized**
   **in that** an access contention evaluation circuit (ZKAS) is provided in the topmost hierarchical level (H2), which, in the case of an access contention of the output ports (D1-DN) of the memory architecture to the same memory block (SB2), enables one output port (D1-DN) involved in the access and inhibits the rest of the output ports (D1-DN) involved in the access.

4. Multiport memory architecture according to Claim 3,
   **characterized**
   **in that** the access contention evaluation circuit (ZKAS) performs a prioritization of the output ports (D1-DN) in accordance with their importance according to a prioritization algorithm.

5. Multiport memory architecture according to one of the preceding claims,
   **characterized**
   **in that** the memory blocks (SB1, SB2) in at least one of the hierarchical levels (H1, H2) are arranged in matrix-type fashion in a memory block matrix (SBM1, SBM2) having a first number of matrix rows and a second number of matrix columns.

6. Multiport memory architecture according to Claim 5,
   **characterized**
   **in that** the first number and/or the second number is a multiple of 2.

7. Multiport memory architecture according to either of Claims 5 and 6,
   **characterized**
   **in that** the memory block matrix (SBM1, SBM2) has at least one row decoder (RAG, WLD) which performs a row selection in the corresponding memory block matrix (SBM1, SBM2) by means of corresponding address bits.

8. Multiport memory architecture according to one of Claims 5 to 7,
   **characterized**
   **in that** the memory block matrix (SBM1, SBM2) has at least one column decoder (SAG, BLD) which performs a column selection in the corresponding memory block matrix (SBM1, SBM2) by means of corresponding address bits.

9. Multiport memory architecture according to one of the preceding claims,
   **characterized**
   **in that** the memory blocks (SB1, SB2) in at least one of the hierarchical levels (H1, H2) are provided in a switching network arrangement.

10. Multiport memory architecture according to one of Claims 1 to 8,
    **characterized**
    **in that** the memory blocks (SB1, SB2) in at least one of the hierarchical levels (H1, H2) are arranged using the so-called banking technique.

**11.** Multiport memory architecture according to one of the preceding claims in a logic component.

**12.** Multiport memory architecture according to Claim 11 having EEPROM memory cells.

**13.** Multiport memory architecture according to one of Claims 1 to 10 in dynamic or static memory components.

**14.** Multiport memory architecture according to Claim 13 having dynamic DRAM memory cells.

**15.** Multiport memory architecture according to Claim 13 having static SRAM memory cells.

**16.** Multiport memory architecture according to one of the preceding claims 1 to 10 in a ROM memory.

**Revendications**

**1.** Architecture mémoire multiports

(a) comprenant plusieurs niveaux hiérarchiques (H1, H2)
(b) comprenant au moins un bloc mémoire (SB1, SB2) dans chacun des niveaux hiérarchiques (H1, H2), les blocs mémoire (SB1) dans le niveau hiérarchique le plus bas (H1) comprenant à chaque fois des cellules mémoire 1 port individuelles qui comprennent à chaque fois des ports individuels avec chacun une connexion de ligne d'adresse (WL1) et des lignes de données (B1,/B1), chaque niveau hiérarchique immédiatement supérieur comprenant des blocs mémoire (SB2) qui sont construits à chaque fois à partir de blocs mémoire (SB2) du niveau hiérarchique immédiatement inférieur (H1),
(c) comprenant des dispositifs de décodage (WLD, BLD, RAG, SAG) dans chacun des niveaux hiérarchiques (H1, H2) pour l'activation, la lecture et l'écriture des blocs mémoire (SB1, SB2) respectifs,
(d) comprenant un circuit de sélection d'adresse (AAS) au moins dans le niveau hiérarchique le plus bas (H1) pour l'injection simultanée de N adresses différentes avec à chaque fois m1 bits d'adresse (A11, ..., AN1) pour l'adressage des blocs mémoire respectifs qui commandent les dispositifs de décodage respectifs (WLD, BLD) de telle façon que pour chacune des N adresses, à chaque fois, un des N mots de données est extrait d'un bloc mémoire correspondant (SB1),
(e) comprenant un circuit tampon de sélection de port (PAP) au moins dans le niveau le plus bas (H1) pour l'affectation du mot de données correspondant extrait à un des ports de sortie (D1, ..., DN) du niveau hiérarchique (H1) correspondant, et
(f) comprenant un circuit tampon d'entrée/sortie (IOP) dans le niveau hiérarchique le plus haut (H2) pour la sélection de blocs mémoire (SB2) du niveau hiérarchique le plus haut (H2),
(g) le circuit tampon de sélection de port (PAP) et le circuit tampon d'entrée/sortie (IOP) comprenant à chaque fois N ports de sortie différents (D1, ..., DN), les N ports de sortie (D1, ..., DN) du circuit tampon d'entrée/sortie (IOP), pour la sortie parallèle des N mots de données, formant les ports de sortie (D1, ..., DN) de l'architecture mémoire.

**2.** Architecture mémoire multiports selon la revendication 1, **caractérisée en ce que** les blocs mémoire (SB1) dans le niveau hiérarchique le plus bas (H1) comprennent des cellules mémoire qui comprennent deux lignes de données (B1) pour introduire et extraire des informations et une ligne de mot (WL1) pour activer la cellule mémoire.

**3.** Architecture mémoire multiports selon l'une quelconque des revendications précédentes, **caractérisée en ce qu'**un circuit d'évaluation de conflit d'accès (ZKAS) est prévu dans le niveau hiérarchique le plus haut (H2), qui dans le cas d'un conflit d'accès des ports de sortie (D1 - DN) de l'architecture mémoire sur le même bloc mémoire (SB2), libère un port de sortie (D1 - DN) impliqué dans l'accès et bloque les ports de sortie (D1 - DN) restants impliqués dans l'accès.

**4.** Architecture mémoire multiports selon la revendication 3, **caractérisée en ce que** le circuit d'évaluation (ZKAS) prévoit l'établissement d'une priorité pour les ports de sortie (D1 - DN) correspondant à leur importance selon un algorithme de priorité.

**5.** Architecture mémoire multiports selon l'une quelconque des revendications précédentes, **caractérisée en ce que** les blocs mémoire (SB1, SB2) dans au moins un des niveaux hiérarchiques (H1, H2) sont organisés sous forme de matrice dans une matrice de bloc mémoire (SBM1, SBM2) avec un premier nombre de lignes de matrice et un deuxième nombre de colonnes de matrice.

6. Architecture mémoire multiports selon la revendication 5, **caractérisée en ce que** le premier nombre et/ou le deuxième nombre sont des multiples de 2.

7. Architecture mémoire multiports selon une des revendications 5 ou 6, **caractérisée en ce que** la matrice de bloc mémoire (SBM1, SBM2) comprend au moins un décodeur de lignes (RAG, WLD) qui prévoit, via des bits d'adresse correspondants, une sélection de ligne dans la matrice de bloc mémoire (SBM1, SBM2) correspondante.

8. Architecture mémoire multiports selon une des revendications 5 à 7, **caractérisée en ce que** la matrice de bloc mémoire (SBM1, SBM2) comprend au moins un décodeur de colonnes (SAG, BLD) qui prévoit, via des bits d'adresse correspondants, une sélection de colonne dans la matrice de bloc mémoire (SBM1, SBM2) correspondante.

9. Architecture mémoire multiports selon l'une quelconque des revendications précédentes, **caractérisée en ce que** les blocs mémoire (SB1, SB2) dans au moins un des niveaux hiérarchiques (H1, H2) sont prévus dans une configuration switching-network.

10. Architecture mémoire multiports selon une des revendications 1 à 8, **caractérisée en ce que** les blocs mémoire (SB1, SB2) dans au moins un des niveaux hiérarchiques (H1, H2) sont organisés suivant la technique dite banking.

11. Architecture mémoire multiports selon l'une quelconque des revendications précédentes dans un composant logique.

12. Architecture mémoire multiports selon la revendication 11 avec des cellules mémoire EEPROM.

13. Architecture mémoire multiports selon une des revendications 1 à 10 dans des composants mémoire dynamiques ou statiques.

14. Architecture mémoire multiports selon la revendication 13 avec des cellules mémoire DRAM dynamiques.

15. Architecture mémoire multiports selon la revendication 13 avec des cellules mémoire SRAM statiques.

16. Architecture mémoire multiports selon une des revendications précédentes 1 à 10 dans une mémoire ROM.

## FIG 1

a)

b)

FIG 2